# EUROPÄISCHE PATENTANMELDUNG

(11) **EP 0 597 337 A1**
(43) Veröffentlichungstag der Anmeldung: **18.05.1994**
(21) Anmeldenummer: 93117571.5
(22) Anmeldetag: 28.10.1993
(51) Int. Cl.: H05K 3/34

(54) **Vorrichtung zum Einebnen von Lotdepots auf den Oberflächen unbestückter Leiterplatten**

(30) Priorität: 09.11.1992 DE 9215230 U
(71) Anmelder: SIEMENS AKTIENGESELLSCHAFT, D-80333 München (DE)
(72) Erfinder: Neubert, Klaus, Dipl.-Ing., D-90530 Wendelstein (DE)

(57) **Zusammenfassung**

Ein erstes Paar (PZ1) an rotierenden Druckzylindern (Z11, Z12) wirkt unter Bildung einer ersten Arbeitszone (AZ1) aufeinander ein. Es sind Tranportmittel (ZF, AF) zur Zu- bzw. Abförderung (FR von Leiterplatten in die bzw. aus der Arbeitszone (AZ1) vorhanden. Jeder Druckzylinder (Z11, Z12) weist einen Zylindermantel (M11,M12) aus teilelastischem Material, zur Abstützung von dessen Rändern zwei Stützringe (R11,R12) aus teilkomprimierbarem Material und einen starren Zylinderkern (K11,K12) zur Halterung der Stützringe auf. Der Zylinderkern (K11,K12) weist Mittel (ZR,ZO, AR,AO) zur Zu- und Abführung einer Heizflüssigkeit in und aus einem Hohlraum (FR) auf. Dieser wird gebildet durch die Innenseiten des Zylindermantels und der Stützringe und durch die Außenseiten des Zylinderkernes. Schließlich sind Mittel zur Aufrechterhaltung vorgegebener Werte des Druckes und der Temperatur der Heizflüssigkeit in den Hohlräumen (FR) der Druckzylinder vorhanden.

## Beschreibung

Vor der endgültigen Bestückung einer Leiterplatte mit elektrischen Bauelementen muß die Leiterplatte u.U. einer größeren Anzahl an Verarbeitungsschritten unterzogen werden. Ein wesentlicher Schritt dieser Art ist das Verzinnen der Leiterplattenoberflächen. Hierbei werden insbesondere Leiterbahnen und Bauelementekontaktflächen, sogenannte "Lötpads", in einer der jeweiligen Schaltung entsprechenden Struktur aufgebracht. Die Lötpads sollen die elektrisch leitende Kontaktierung der Anschlußelemente von elektrischen Bauelementen mit den Leiterbahnen ermöglichen.

Diese Lötpads bilden somit Lotdepots, welche nach der Bauelementebestückung z.B. durch Wärmebehandlung der Leiterplatte aufgeschmolzen werden. In das geschmolzene Lot eines jeden Pads kann dann der Auflagebereich eines Anschlußelementes eines elektrischen Bauteiles einsinken. Die hierbei auftretende Benetzung des Anschlußelementes mit Lötmittel bewirkt nach Erstarrung desselben eine sichere elektrisch leitende Kontaktierung mit den Leiterbahnen.

Lötpads weisen nach Aufbringung auf die Leiterplattenoberfläche zunächst eine nicht ebene, sondern gewölbte Oberseite auf. Derart geformte Lötpads sind aber zur Bestückung insbesondere mit oberflächenmontierbaren Bauelementen, sogenannten "Surface Mount Devices" SMD, noch nicht ausreichend geeignet. Unmittelbar nach der Bestückung kann nämlich u.U. ein Abrutschen von Bauelemente-Anschlußelementen von der linsenförmigen Lötpadoberseite auftreten bzw. es erfolgt keine ausreichende Benetzung der Anschlußelemente beim Aufschmelzen des Lotes. So müssen derartige Lötpads eine möglichst ebene Oberfläche und homogene Lotschichtdicke von ca. 50 bis 70 um aufweisen. Lötpads mit gewölbter Außenseite müssen somit durch einen "Einebnungsvorgang" für die Bestückung insbesondere mit oberflächenmontierbaren Bauteilen vorbereitet werden.

Dieser Einebnungsvorgang ist aber verfahrenstechnisch außerordentlich schwierig zu beherrschen, da die Maßnahmen zur Aufwärmung und mechanischen Bearbeitung der Leiterplattenoberfläche sehr genau aufeinander abgestimmt werden müssen.

Der Erfindung liegt somit die Aufgabe zugrunde, eine Vorrichtung anzugeben, welche es gestattet, den Aufschmelzvorgang der Lotdepots unter genau kontrollierten Bedienungen und gleichzeitiger mechanischer Formung der Pads derart schnell ablaufen zu lassen, daß diese nach dem Erstarren eine möglichst ebene Oberfläche und eine möglichst gleichmäßige Dicke aufweisen. Die Aufgabe wird gelöst mit der im Patentanspruch angegebenen Vorrichtung. Vorteilhafte Ausführungsformen derselben sind in den Unteransprüchen angegeben. Die Erfindung wird unter Zuhilfenahme der nachfolgend kurz angeführten Figuren näher erläutert. Dabei zeigt
FIG 1 eine bevorzugte Ausführungsform der Erfindung mit einer Vorwärmvorrichtung und zwei hintereinander angeordneten Paaren von rotierenden Druckzylindern, und
FIG 2 eine bevorzugte Ausführungsform eines gemäß der Erfindung aufgebauten Druckzylinders der Vorrichtung.

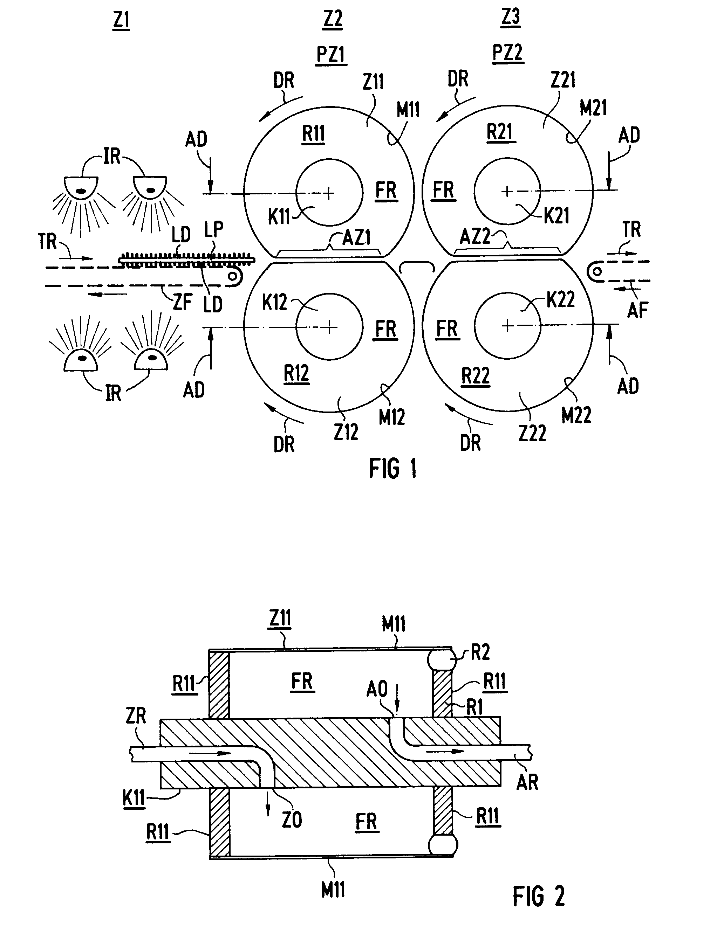

Gemäß der Darstellung in FIG 1 weist die erfindungsgemäße Vorrichtung zumindest ein erstes Paar PZ1 an rotierenden Druckzylindern Z11 und Z12 auf. Diese sind bevorzugt mit Hilfe von Mitteln AD zur Einstellung der Vertikalposition so relativ zueinander angeordnet, daß sich eine dazwischenliegende erste Arbeitszone AZ1 ergibt. Erfindungsgemäß sind die Druckzylinder nicht starr, sondern teilweise aus teilelastischem bzw. teilkomprimierbarem Material gefertigt. Bei entsprechend naher vertikaler Positionierung AD der beiden Zylinder Z11 und Z12 tritt somit im Kontaktbereich der Druckzylindern eine Verformung derselben auf. Hierdurch wird eine erste Arbeitszone AZ1 gebildet, durch die bei Rotation der Druckzylinder Z11,Z12 in Drehrichtung DR unbestückte Leiterplatten zum Zwecke der Einebnung von Lotdepots hindurchgefördert werden können.

Hierzu weist die erfindungsgemäße Vorrichtung Transportmittel zur Zu- bzw. Abförderung von Leiterplatten in die bzw. von der ersten Arbeitszone AZ1 zwischen dem Druckzylinderpaar PZ1 auf. Im Beispiel der FIG 1 ist eine derartige Zufördereinrichtung ZF auf der linken Seite des ersten Paares PZ1 beispielhaft in Form eines Förderbandes dargestellt. Dessen Transportrichtung TR ist auf den Eingang in die erste Arbeitszone AZ1 gerichtet. In FIG 1 ist beispielhaft eine unbestückte Leiterplatte LP auf der Oberseite der Zufördereinrichtung ZF in einer Position unmittelbar vor deren Eintritt in die erste Arbeitszone AZ1 zwischen dem ersten Paar PZ1 an rotierenden Druckzylindern dargestellt. Zur Veranschaulichung sind auf beiden Seiten der Leiterplatte LP Lotdepots LD in nicht maßstabsgerechter Darstellung in Form von Nadeln dargestellt. Erfindungsgemäß sollen diese Lotdepots LD nach Durchlauf durch die Arbeitszone AZ1 in der gewünschten Weise eingeebnet und somit zur Bestückung insbesondere mit oberflächenmontierbaren Bauelementen vorbereitet sein. In FIG 1 ist schließlich dem mindestens einen Paar PZ1 an rotierenden Druckzylindern Z11,Z12 eine ebenfalls in Form eines Transportbandes dargestellte Abfördereinrichtung AF für die Leiterplatten LP nachgeschaltet.

Zur Bildung der ersten Arbeitszone AZ1 weist jeder der Druckzylinder Z11 bzw. Z12 einen Zylindermantel M11 bzw. M12 aus einem teilelastischen Material auf, welcher an den Rändern durch jeweils zwei Stützringe R11 bzw. R12 aus einem teilkomprimierbarem Material abgestützt werden. Die Stützringe R11 bzw. R12 sind ihrerseits auf der Außenseite jeweils eines starren Zylinderkerns K11 bzw. K12 angeordnet. Die Zylinderkerne weisen Mittel auf, womit eine Heizflüssigkeit durch einen Hohlraum FR im jeweiligen Druckzylinder hindurchgefördert werden kann. Dieser wird jeweils durch die Innenseiten des Zylindermantels und der dazugehörigen Stützringe, und durch die Außenseiten des dazugehörigen Zylinderkernes gebildet.

In der FIG 2 ist beispielhaft der Druckzylinder Z11 in einem Längsschnitt dargestellt. Auf dem starren Zylinderkern K11 sind jeweils zwei Stützringe R11 aus teilkomprimierbarem Material angeordnet und unterstützen einen Zylindermantel M11 aus teilelastischem Material im Bereich von dessen Rändern. Erfindungsgemäß wird durch den aus diesen Elementen gebildeten Hohlraum FR eine Heizflüssigkeit hindurchgefördert. Als Mittel zu deren Zu- und Abförderung dienen im Beispiel der FIG 2 ein Zuförderrohr ZR und ein Abführrohr AR im Inneren des Zylinderkernes K11. Dabei mündet das Zuförderrohr ZR über eine Einspritzöffnung ZO im Mantel des Zylinderkernes K11 in den Hohlraum FR, während die Heizflüssigkeit über eine Absaugöffnung AO im Mantel des Zylinderkernes K11 in das Abführrohr AR eintritt. Im Beispiel der FIG 2 ist der linke der beiden Stützringe R11 beispielhaft vollständig aus einem teilkomprimierbarem Material gefertigt. Dagegen weist der rechte der beiden Stützringe R11 eine andere Ausführungsform auf. Dieser ist beispielhaft zweiteilig ausgeführt, wobei auf einen starren inneren Teilring R1 ein teilkomprimierbarer äußerer Teilring R2 in der Art eines Reifens aufgezogen ist.

Die erfindungsgemäße Vorrichtung verfügt schließlich über Mittel zur Aufrechterhaltung vorgegebener Werte des Druckes und der Temperatur der Heizflüssigkeit im Hohlraum FR des jeweiligen Druckzylinders. Bevorzugt geben die Mittel zur Aufrechterhaltung des Druckes im jeweiligen Hohlraum FR den Druckwert abhängig von der vertikalen Position AD der Druckzylinder Z11,Z12 des ersten Paares PZ1 derart vor, daß sich eine über die gesamte Breite der Druckzylinder möglichst ebene erste Arbeitszone AZ1 mit vorgegebener Tiefe einstellt.

Ferner beeinflussen die Mittel zur Aufrechterhaltung der Temperatur der Heizflüssigkeit im jeweiligen Hohlraum FR bevorzugt die Fördergeschwindigkeit der Heizflüssigkeit durch den Hohlraum. So wird z.B. bei einem unerwünschten Rückgang der Temperatur die Fördergeschwindigkeit der Heizflüssigkeit durch den Hohlraum erhöht, um Wärmeverluste auszugleichen und die Zylindermanteltemperatur auf einem gewünschten Sollwert zu halten.

Werden die Parameter "Rotationsgeschwindigkeit", "Relative Vertikalposition AD" und "Temperatur" der Mäntel M11,M12 der Druckzylinder Z11,Z12 des ersten Paares PZ1 in geeigneter Weise aufeinander abgestimmt, so können mit einer hohen Durchsatzgeschwindigkeit die Lötdepots LD auf den Außenseiten von Leiterplatten in der gewünschten Weise eingeebnet werden.

Hierbei werden die Lotdepots auf der Oberfläche einer Leiterplatte nach Eintritt in die Arbeitszone AZ1 zumindest geringfügig aufgeschmolzen, beim Durchlauf durch die Arbeitszone aufgrund des dort herrschenden gleichmäßigen Andruckes eingeebnet und aufgrund der Abkühlung der Zylindermäntel durch den Wärmeübergang auf die dazwischen liegende Leiterplatte im Austrittsbereich der ersten Arbeitszone wieder bis zum Eintritt der Erstarrung abgekühlt. Bei geeigneter Abstimmung der obengenannten Parameter bildet sich somit im Inneren der Arbeitszone AZ1 ein Temperaturprofil aus. Bevorzugt sind die Zylindermäntel Z11, Z12 beim Zusammentreffen auf der Eintrittsseite der Arbeitszone so heiß, daß zumindest eine Erweichung der Lotdepots auftritt. Aufgrund des Wärmeabflusses auf die zwischen den Druckzylindern liegende Leiterplatte kühlen sich die Zylindermäntel beim Durchlauf durch die Arbeitzone zunehmend ab, so daß diese gegen Ende der Arbeitszone wieder "kühlend" auf die Leiterplattenoberfläche einwirken. Mit Austritt der Leiterplatte aus der Arbeitszone sind die Lotdepots wieder erstarrt und weisen die gewünschte eingeebnete Oberfläche auf.

Bei einer weiteren, in FIG 1 bereits dargestellten Ausführungsform der Erfindung können zusätzliche Mittel zur Vorwärmung der Leiterplatte LP vorgesehen sein. Diese sind in einer ersten Zone Z1 im Bereich der Mittel zur Zuführung ZF der Leiterplatten vor dem ersten Paar PZ1 an Druckzylindern Z11, Z12 angeordnet. Im Beispiel der FIG 1 bestehen diese Mittel aus Infrarotwärmestrahlern IR, welche jede durchlaufende Leiterplatte LP beidseitig aufwärmen. Die erfindungsgemäße Vorrichtung weist bei dieser Ausführung zwei Zonen Z1 und Z2 auf. In der ersten Zone Z1 erfolgt zumindest eine Vorwärmung der Lotdepots auf der Leiterplatte, während in der zweiten Zone Z2 im wesentlichen die Einebnung und anschließende Abkühlung bis zur Erstarrung der Lotdepots stattfindet. Die auf zwei Zonen Z1, Z2 erweiterte erfindungsgemäße Vorrichtung hat den Vorteil, daß die Verfahrensschritte "Aufschmelzen", "Einebnen" und "Abkühlen" der Lotdepots in gewisser Weise räumlich voneinander getrennt sind, und somit besonders gut aufeinander abgestimmt werden können. Insbesondere sind die Mittel IR zur Vorwärmung der Leiterplatte in der ersten Zone Z1 und die Mittel zur Aufrechterhaltung der Temperatur der Heizflüssigkeit in den Hohlräumen der rotierenden Druckzylinder Z11, Z12 in der zweiten Zone Z2 so aufeinander abgestimmt, daß die Lotdepots einer Leiterplatte beim Passieren der ersten Zone Z1 nahezu vollständig aufgeschmolzen werden und die Druckzylinder in der zweiten Zone Z2 mittels der genau temperierten Zylindermäntel M11, M12 die Funktion der "Planierung" und "Abkühlung" bis zum Eintritt der Loterstarrung übernehmen.

Bei einer weiteren, in der FIG 1 ebenfalls dargestellten Ausführungsform der Erfindung ist im Anschluß an das erste Paar PZ1 an Druckzylindern Z11, Z12 ein zweites Paar PZ2 an Druckzylindern Z21, Z22 angeordnet. Eine Leiterplatte LP durchläuft somit zuerst die Arbeitszone AZ1 zwischen den Druckzylindern Z11, Z12 und anschließend die Arbeitszone AZ2 zwischen den Druckzylindern Z21, Z22. In diesem Fall weist die erfindungsgemäße Vorrichtung die beiden Zonen Z2 und Z3 mit jeweils einem Paar PZ1 bzw. PZ2 an rotierenden Druckzylindern auf. Dabei wird bevorzugt die Temperatur der Heizflüssigkeit in den Hohlräumen FR des zweiten Druckzylinderpaares Z21, Z22 auf einen niedrigeren Wert als in den Hohlräumen des ersten Druckzylinderpaares Z21,Z22 eingestellt. Dies hat zur Folge, daß die Temperatur der Mäntel M11, M12 der Druckzylinder in der Zone Z2 so hoch ist, daß beim Durchlauf einer Leiterplatte LP im wesentlichen eine "Vorwärmung" und "Aufschmelzung" der Lotdepots LD im Inneren der ersten Arbeitszone AZ1 stattfindet. Demgegenüber weisen die Mäntel M21, M22 des Druckzylinderpaares in der darauffolgenden Zone Z3 eine geringere Temperatur auf, so daß nach Übertritt der Leiterplatte in die zweite Arbeitszone AZ2 im wesentlichen eine "Einebnung" und "Abkühlung" bis zur erneuten Erstarrung der Lotdepots bewirkt wird. So weist auch die Ausführung mit zwei aufeinander folgenden Paaren an Druckzylindern den besonderen Vorteil auf, daß die Prozesse der "Aufschmelzung", "Planierung" und "Abkühlung" wiederum durch räumliche Trennung und geeignete Temperatursteuerung der Heizflüssigkeiten in den Druckzylinderpaaren besonders gut aufeinander abgestimmt werden können.

Schließlich können bei der erfindungsgemäßen Vorrichtung auch alle drei Zonen Z1, Z2, Z3 gemäß der Darstellung in FIG 1 gleichzeitig vorhanden sein. In diesem Fall werden bevorzugt die Lotdepots von Leiterplatten beim Durchlauf durch die Zone Z1 z.B. durch Infrarotwärmestrahler IR vorgewärmt, beim Durchlauf durch die Zone Z2 in der ersten Arbeitszone AZ1 zwischen den rotierenden Druckzylindern Z11, Z12 vollständig aufgeschmolzen und eingeebnet, und schließlich in der Zone Z3 bei Durchlauf durch die zweite Arbeitszone AZ2 zwischen den Druckzylindern Z21,Z22 stark abgekühlt. Eine derartige Dreizonenanordnung hat somit den Vorteil, daß ein ausgeprägtes Temperaturprofil eingestellt werden kann, und die Funktionen "Aufwärmen/Aufschmelzen" und "Abkühlen" räumlich von der Funktion "Einebnen" getrennt werden können.

Gemäß einer letzten Ausführungsform der Erfindung weisen die Mäntel M11, M12, M21, M22 der jeweiligen Druckzylinder Z11, Z12, Z21, Z22 auf den Außenseite antihaftende Eigenschaften auf. Hierzu kann ein aus Federstahl bestehender Zylindermantel mit einem organischen Material bzw. auf galvanische Weise beschichtet werden. Bei einer ander Ausführungform werden die antihaftenden Eigenschaften durch eine Oxidation der Zylindermantelaußenseiten bewirkt. Eine derartige Ausführung der Druckzylinder hat den Vorteil, daß im Moment des Aufschmelzens kein Lot von den einzuebnenden Lotdepots abgehoben wird. Nach dem Erstarren kann somit eine gewünschte Lotdepotstärke mit einer hohen Genauigkeit erreicht werden.

## Patentansprüche

1. Vorrichtung zum Einebnen von Lotdepots (LD) auf den Oberflächen unbestückter Leiterplatten (LP), mit
a) zumindest einem ersten Paar (PZ1) an rotierenden Druckzylindern (Z11,Z12), welche unter Bildung einer ersten Arbeitszone (AZ1) aufeinander einwirken,
b) Transportmitteln (ZF,AF) zur Zu- bzw. Abförderung (TR) von Leiterplatten (LP) in die bzw. von der ersten Arbeitszone (AZ1), und wobei
c) jeder Druckzylinder (Z11,Z12) aufweist c1) einen Zylindermantel (M11,M12) aus teilelastischem Material,
c2) jeweils zwei Stützringe (R11,R12) aus teilkomprimierbarem Material, welche den Zylindermantel (M11, M12) im Bereich von dessen Rändern abstützen, und
c3) einen starren Zylinderkern (K11,K12), auf dem die Stützringe (R11,R12) angeordnet sind und der Mittel (ZR,ZO;AR,AO) zur Zu- und Abführung einer Heizflüssigkeit in und aus einem Hohlraum (FR) aufweist, welcher durch die Innenseiten des Zylindermantels (M11,M12) und der Stützringe (R11,R12) und durch die Außenseiten des Zylinderkernes gebildete wird, und mit
d) Mitteln zur Aufrechterhaltung vorgegebener Werte des Druckes und der Temperatur der Heizflüssigkeit in den Hohlräumen (FR) der Druckzylinder (Z11,Z12).

2. Vorrichtung nach Anspruch 1 mit zusätzlichen Mitteln (IR) zur Vorwärmung der Leiterplatte (LP), welche in einer ersten Zone (Z1) im Bereich der Mittel zur Zuführung (ZF) der Leiterplatten (LP) vor dem ersten Paar (PZ1) an Druckzylindern (Z11,Z12) angeordnet sind, insbesondere Infrarotwärmestrahler.

3. Vorichtung nach einem der vorangegangenen Ansprüche, wobei
a) im Anschluß an das erste Paar (PZ1) an Druckzylindern (Z11,Z12) ein zweites Paar (PZ2) an Druckzylindern (Z21, Z22) angeordnet ist, und
b) die Heizflüssigkeit in den Hohlräumen (FR) des zweiten Druckzylinderpaares (Z21,Z22) auf einen niedrigeren Temperaturwert als in den Hohlräumen (FR) des ersten Druckzylinderpaares (Z21,Z22) eingestellt ist (Fig. 1).

4. Vorrichtung nach einem der vorangegangenen Ansprüche, wobei den Mitteln zur Aufrechterhaltung des Druckes der Heizflüssigkeit im Hohlraum (FR) eines Druckzylinders (Z11, Z12;Z21,Z22) der Druckwert abhängig von der vertikalen Position (AD) der Druckzylinder (Z11,Z12;Z21,Z22) des jeweiligen Paares (PZ1,PZ2) derart vorgegeben wird, daß sich eine über deren gesamte Breite möglichst ebene Arbeitszone (AZ1,AZ2) ergibt.

5. Vorrichtung nach einem der vorangegangenen Ansprüche, wobei die Mittel zur Aufrechterhaltung der Temperatur der Heizflüssigkeit im Hohlraum (FR) eines Druckzylinders (Z11, Z12;Z21,Z22) deren Fördergeschwindigkeit durch den Hohlraum (FR) beeinflussen.

6. Vorrichtung nach einem der vorangegangenen Ansprüche, wobei der Zylindermantel (M11,M12;M21,M22) des jeweiligen Druckzylinders (Z11,Z12;Z21,Z22) aus Federstahl besteht und dessen Außenseite antihaftende Eigenschaften aufweist.
